# EUROPEAN PATENT APPLICATION

(11) **EP 3 527 504 A1**
(43) Date of publication of application: **21.08.2019**
(21) Application number: 17893503.7
(22) Date of filing: 29.12.2017
(51) Int. Cl.: B65D 81/26

(54) **PACKAGING BOX CAPABLE OF GENERATING ELECTRICITY**

(30) Priority: 20.12.2017 CN 201711389795; 20.12.2017 CN 201711389795
(71) Applicant: MiaSole Photovoltaic Technology Co., Ltd., Fengtai District, Beijing 100070 (CN)
(72) Inventor: ZHANG, Bo, Fengtai District Beijing 100070 (CN); YANG, Sheng, Fengtai District Beijing 100070 (CN)
(74) Representative: Cabinet Beau de Loménie
(86) International application number: PCT/CN2017/119656
(87) International publication number: WO 2019/119510

(57) **Abstract**

The present application discloses a packaging box capable of generating power, which comprises: a box body, solar chips and a regulated voltage output terminal; wherein the box body can be unfolded to form a plurality of wall plates, two adjacent ones of the wall plates are interconnected; the solar chips are arranged on the wall plates, and are connected in series or in parallel via a leading wire; and the regulated voltage output terminal is electrically connected with the solar chips. With the present application, packaging boxes are changed from disposables into green and environmentally-friendly multi-purpose products, thereby effectively solving the problem that traditional packaging boxes are featured by functional singleness, such that waste of resources could readily occur.

## Description

### Field of the Application

The present application relates to the field of solar power generation application, and more particularly, to a packaging box capable of generating power.

### Background of the Application

It is well-known that packaging boxes are used for storing commodities or gifts. However, if not reused, most of them would be left unused or even discarded after the contents are take out therefrom. As a result, existing packaging boxes have long been featured by functional singleness, such that waste of resources could readily occur.

### Summary of the Application

It is an object of the present application to provide a packaging box capable of generating power, wherein the packaging box capable of generating power is combined with solar chips to achieve its effective recycling.

The technical solution set forth in the present application is as follows:
a packaging box capable of generating power is provided, which comprising: a box body that can be unfolded to form a plurality of wall plates, wherein two adjacent wall plates are interconnected; and solar chips and a regulated voltage output terminal;
wherein the solar chips are arranged on the wall plates, and are connected in series or in parallel via a leading wire,
and the regulated voltage output terminal is electrically connected with the solar chips.

Preferably, a wear-resistant layer of encapsulation material is arranged on the surface of each of the solar chips.

Preferably, the box body is further provided with an extension port connected electrically with the solar chips.

Preferably, the regulated voltage output terminal is a magnetic charging module.

Preferably, the packaging box capable of generating power is a magnetic attraction-type packaging box having a covering plate;
the magnetic charging module is fixedly arranged on one of the wall plates, and the covering plate is provided with a magnetically attractive material;
the magnetic charging module and the magnetically attractive material are mutually attracted when the packaging box capable of generating power is in a packaged state.

Preferably, the solar chips are film-type power-generating paper.

Preferably, the packaging box capable of generating power also comprises functional modules connected electrically with the solar chips, wherein these functional modules comprise any one or more of an energy storage module, a voltage monitoring module, a battery status detection module, an overcurrent and overvoltage protection module or an output indication module.

Preferably, the leading wire is pre-embedded into the box body.

Preferably, the solar chips are embedded into the wall plates, or arranged on the surfaces thereof. Preferably, the packaging box capable of generating power further comprises a protective sheath sleeved on the regulated voltage output terminal.

In the present application and preferred embodiments thereof, solar chips are combined with a traditional packaging box. As such, the packaging box can be unfolded to become an independent solar power generating body, and electric energy converted by the solar chips can be delivered to a desired device by means of the regulated voltage output terminal. With the present application, packaging boxes are changed from disposables into green and environmentally-friendly multi-purpose products, thereby solving the problem that traditional packaging boxes are featured by functional singleness, such that waste of resources could readily occur.

### Brief Description of the Accompanying Drawings

In order to facilitate the understanding of the object, the technical solution and advantages of the present application, the present application will now be described below in greater detail in conjunction with the accompanying drawings, wherein:
Figure 1 is a schematic diagram illustrating a packaging box capable of generating power in an opened state in accordance with an embodiment of the present application;
Figure 2 is a schematic diagram illustrating a box body in an unfolded state in accordance with an embodiment of the present application.

Reference numerals are illustrated as follows:
100-box body; 200-drawer-type inner box; 1-wall plate; 2-solar chip; 3-regulated voltage output terminal.

### Detailed Description of the Preferred Embodiments

The embodiments of the present application will now be described below in detail. Examples of these embodiments are shown in the accompanying drawings, in which identical or similar reference numerals denote identical or similar elements or elements having identical or similar functions throughout the views. The embodiments described below in conjunction with the accompanying drawings are exemplary and merely for the purpose of explaining the present application, and should not be construed as limitations thereto.

The present application provides a packaging box capable of generating power, which combines solar chips with a traditional packaging box. The first thing to point out is that the present application is widely applicable, and not limited to materials of traditional packaging boxes or packaging manners thereof. Materials for packaging boxes may be any one or a combination of paper, plastics, leather, metals, etc.; moreover, packaging forms for packaging boxes may be any one or a combination of pulling-type packaging, wrapped-type packaging, snap-type packaging, magnetic attraction-type packaging, folding and splicing-type packaging, etc.

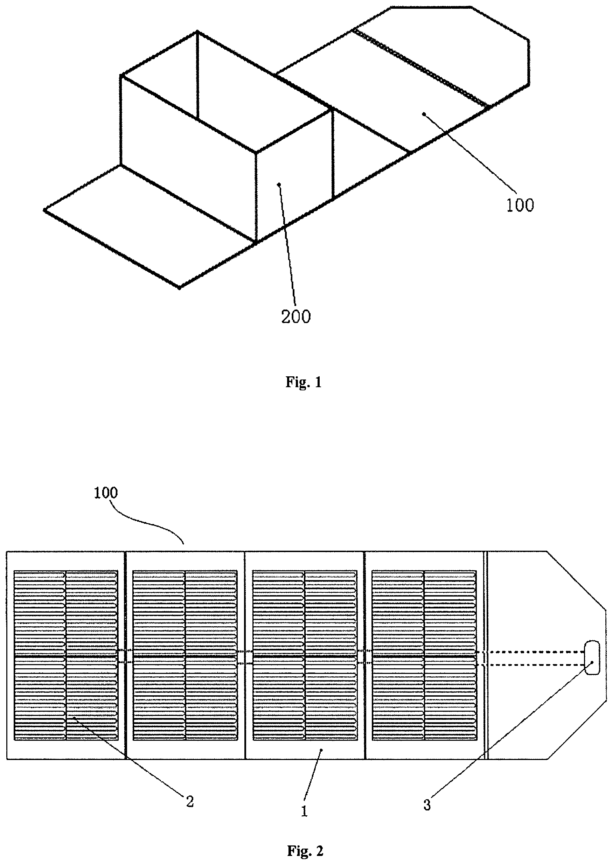

Specifically, with respect to the embodiments of the present application as shown in Figures 1 and 2, the packaging box capable of generating power comprises a box body 100 that can be unfolded to form a plurality of wall plates 1, wherein two adjacent wall plates 1 are interconnected in a foldable manner. In other words, a folding region is arranged between adjacent wall plates 1. It is certain that in other embodiments, adjacent wall plates 1 may also be connected with each other via a flexible connector, or by means of an adhesive. It should be noted that the implementations shown in the accompanying drawings are based on a wrapped-type packaging box as mentioned above. As a result, the box body 100 as mentioned herein is one which is wrapped outside the inner box 200. It is certain that in other embodiments, the inner box 200 may also be unfolded to form a structure similar to that of the box body 100, which exerts no influence on the implementation of the present application. Moreover, as for other types of packaging boxes, they may not be provided with inner boxes 200. For example, the accommodating space for items to be placed therein is directly formed by a folded box body. The packaging box capable of generating power is distinguished from the traditional packaging box in that it also comprises solar chips 2 and a regulated voltage output terminal 3. Specifically, these solar chips 2 are arranged on the wall plates 1, and are connected in series/in parallel via leading wires (as shown by dotted lines in the figure); and the regulated voltage output terminal 3 is electrically connected with the solar chips 2 so as to provide electric energy converted thereby to other devices. Here, selection types of the solar chips 2 may be diversified. For example, these solar chips may be flexible chips or film-type power-generating paper. Moreover, the arrangement manner for the solar chips 2 and the wall plates 1 may also be combined with the material of the packaging box and the selection types of the solar chips 2. The solar chips may be embedded into the wall plates 1 or arranged on the surfaces thereof, and fixed arrangement may be achieved through the following manners, such as fixed connection via screws, integrated lamination molding or adhesive connection. For example, adhesive films are arranged between the solar chips 2 and the wall plates 1.

There will be described below the supplementary explanations on the above embodiments:
First, in the case that the solar chips 2 are arranged on the wall plates 1, they may be arranged on the inner or outer walls of the wall plates 1. The so-called inner walls of the wall plates 1 refer to the sides of the wall plates 1 that face towards the interior of a box when the box body 100 is in a folded state, while the outer walls refer to the sides that face away from the interior of the box and are generally provided for commodity information, various patterns and the like to be printed thereon; as a result, the present application further involves protecting the solar chips 2 during placement of items and transportation. In other words, a wear-resistant layer of encapsulation material is arranged on the surface of each solar chip 2 so as to avoid the damage caused by the direct contact of solar chips 2 with external items or contents and the like; certainly, the entire surface of each wall plate 1 may also be encapsulated by wear-resistant materials, thereby offering more comprehensive and reliable protection.

Secondly, during practical operations, the leading wires for the solar chips 2 on various wall plates 1 may be wire cables (or bus bars) led out from respective solar chips 2, which are manually connected after the box body is unfolded. Certainly, in the case that such practice is adopted, further consideration needs to be made to the issue of storage and fixing of the leading wires in a packaged state; for example, channels may be arranged between various wall plates 1 of the packaging box for the leading wires to pass therethrough; more preferably, the leading wires are pre-embedded into the interior of the box body between various wall plates 1. As such, they can be well protected, and meanwhile, the packaging box may have a neat appearance. On this basis, the leading wires may be made of bending-resistant materials.

Thirdly, based on the above implementations, the combined application of a plurality of packaging boxes may also be achieved. In other words, an extension port may be arranged on the box body 100 to be electrically connected with the foregoing solar chips 2. As a reserved to-be-plugged port, this extension port may achieve series and parallel connection between the solar chips 2 of a plurality of packaging boxes capable of generating power, thereby forming a large-sized power generating body composed of a plurality of packaging boxes capable of generating power. And that is the reason why this reserved to-be-plugged port is named herein as the extension port.

Fourthly, take the paper-type packaging box capable of generating power as an example. The leading wire for each solar chip 2 may be led out to achieve the function of independent output. In other words, the paper wall plates 1 may be cut into a plurality of independent solar power generating bodies.

From the foregoing, with the present application, traditional packaging boxes are changed from disposables into green and environmentally-friendly multi-purpose products. This means that when you purchase a commodity, you will be offered a small-scaled power generating device. Therefore, the actual structure of the foregoing regulated voltage output terminal 3 may be adjusted as required. For example, this regulated voltage output terminal may be a positive and negative cable knob for external connection, and may also be a USB port for charging electronic devices. In a preferred embodiment of the present application, this regulated voltage output terminal 3 is a magnetic charging module. For specific contents, reference may be made to the charging manners of conventional power banks, apple watch, and the like. The regulated voltage output terminal 3 does not need to be fixedly arranged on the box body, and charging may be achieved via a plugging port connected therewith by means of a wire cable. For example, in the case of the magnetic charging module, when an electronic device is engaged with the magnetic charging module, electric energy can be generated for charging. Further, based on this preferred embodiment, the packaging box capable of generating power as provided by the present application may be a magnetic attraction-type packaging box having a covering plate. In other words, a magnetically attractive material (e.g., an iron component) may be mounted within the covering plate, and the foregoing magnetic charging module 3 may be fixedly arranged on a wall plate 1 in this implementation. When the packaging box capable of generating power is in a packaged state (i.e. that wall plates 1 are in a folded state), the foregoing magnetic charging module and the magnetically attractive material of the covering plate may be mutually attracted. In other words, the covering plate is in closed engagement with the wall plates, thereby covering the packaging box capable of generating power. Certainly, those skilled in the art may appreciate that based on the packaging manners for various types of packaging boxes as mentioned above, the covering plate may be connected with the wall plates, and may also be separated from the box body. In addition, it should also be noted that in view of the terminal structures for the foregoing various regulated voltage output terminals, a protective sheath may be provided, which is sealingly sleeved on each regulated voltage output terminal, thereby exhibiting dirt-repellent and electrical shielding effects.

Further, in another preferred embodiment of the present application, the packaging box capable of generating power also comprises a plurality of functional modules connected electrically with the solar chips 2, wherein these functional modules comprise, without limitation, one or more of an energy storage module for storing electric energy converted by the solar chips, a voltage monitoring module for detecting the voltage of the solar chips 2, a battery status detection module for monitoring the status of the solar chips, an overcurrent and overvoltage protection module for preventing output failure and avoiding impact on external devices, and an output indication module for indicating output status information. Alternatively, they may further comprise a wireless communication module combined with a mobile terminal, namely a module capable of displaying the information of the foregoing various modules on the mobile terminal, such as residual capacity of the energy stored, output voltage, failure warning, etc. It should be noted that the above modules may be integrated or separately arranged, and their specific positions and numbers may be adjusted according to the size of the packaging box and available space. For example, if the space is sufficient within the box, then a plurality of functional modules may be arranged within the box (which are located in the same space as the contents) or on the wall plates thereof by means of gluing.

Finally, another two points are illustrated as follows: Firstly, after unfolding, the packaging box capable of generating power may be used in a further application: after unfolding, the packaging box capable of generating power, which is originally three-dimensional in form, may be folded for a second time, such that it is thinner and lighter, and is portable and easy to store (for example, it may be folded for a second time to be relatively flat in form), just like the power bank or mobile power source. Secondly, the packaging box in this application is not limited in size, nor is it limited in the box structure in practical applications. Therefore, for those skilled in the art, the present application may be developed as other application forms, such as packaging boxes, storage cabinets, etc.

Although the above embodiments as shown from the figures illustrate in detail the configuration, features and effects of the present application, what have been described above arc merely preferred embodiments of the present application. It should be noted that without departing from or changing the design concept and technical effects of the present application, those skilled in the art may reasonably combine and match the technical features involved in the above embodiments and preferred implementations thereof so as to achieve multiple equivalent solutions. Therefore, in the present application, the implementation range is not limited to what's illustrated in the drawings. Without departing from the spirit as covered by the description and the figures, all the changes that are made based on the concept of the present application, or the equivalent embodiments that are modified as equivalent changes, shall be covered by the scope of protection of the present application.

### Industrial Applicability

As for traditional packaging boxes, most of them would be left unused or even discarded after the contents are retrieved therefrom. As a result, they have long been featured by functional singleness, thereby excessively wasting resources and increasing costs.

However, the packaging box capable of generating power as provided by the present application is a groundbreaking application, in which the green and environmentally-friendly solar power techniques arc combined with the traditional packaging box, such that the packaging box may be unfolded to form an independent solar power generating body, and the electric energy converted by the solar chips is delivered to a desired device via the regulated voltage output terminal, thereby changing traditional packaging boxes from disposables into multi-purpose products. Therefore, for today's industrialized society nagged by energy and environmental crises, the present application has prominent advantages in terms of industrial applicability, such as energy conservation, environmental protection, etc.

## Claims

1. A packaging box capable of generating power, comprising:
a box body, solar chips and a regulated voltage output terminal;
wherein the box body can be unfolded to form a plurality of wall plates, wherein two adjacent wall plates are interconnected;
the solar chips are arranged on the wall plates, and are connected in series or in parallel via a leading wire; and
the regulated voltage output terminal is electrically connected with the solar chips.

2. The packaging box capable of generating power according to claim 1, wherein a wear-resistant layer of encapsulation material is arranged on the surface of each of the solar chips.

3. The packaging box capable of generating power according to claim 1, wherein the box body is further provided with an extension port connected electrically with the solar chips.

4. The packaging box capable of generating power according to claim 1, wherein the regulated voltage output terminal is a magnetic charging module.

5. The packaging box capable of generating power according to claim 4, wherein the packaging box capable of generating power is a magnetic attraction-type packaging box having a covering plate;
wherein the magnetic charging module is fixedly arranged on one of the wall plates, and the covering plate is provided with a magnetically attractive material; and
the magnetic charging module and the magnetically attractive material are mutually attracted when the packaging box capable of generating power is in a packaged state.

6. The packaging box capable of generating power according to any one of claims 1 to 5, wherein the solar chips are film-type power-generating paper.

7. The packaging box capable of generating power according to any one of claims 1 to 5, wherein the packaging box capable of generating power also comprises functional modules connected electrically with the solar chips, wherein the functional modules comprise any one or more of an energy storage module, a voltage monitoring module, a battery status detection module, an overcurrent and overvoltage protection module or an output indication module.

8. The packaging box capable of generating power according to any one of claims 1 to 5, wherein the leading wire is pre-embedded into the box body.

9. The packaging box capable of generating power according to any one of claims 1 to 5, wherein the solar chips are embedded into the wall plates, or arranged on the surfaces thereof.

10. The packaging box capable of generating power according to any one of claims 1 to 5, wherein the packaging box capable of generating power further comprises a protective sheath sleeved on the regulated voltage output terminal.
